(19) Europäisches Patentamt
European Patent Office
Office européen des brevets

(11) **EP 2 215 531 B1**

(12) **FASCICULE DE BREVET EUROPEEN**

(45) Date de publication et mention
de la délivrance du brevet:
**09.03.2011 Bulletin 2011/10**

(21) Numéro de dépôt: **07822869.9**

(22) Date de dépôt: **28.11.2007**

(51) Int Cl.:
***G04B 1/14*** *(2006.01)*      ***G04B 17/22*** *(2006.01)*

(86) Numéro de dépôt international:
**PCT/EP2007/062941**

(87) Numéro de publication internationale:
**WO 2009/068091 (04.06.2009 Gazette 2009/23)**

(54) **OSCILLATEUR MÉCANIQUE PRÉSENTANT UN COEFFICIENT THERMOÉLASTIQUE OPTIMISÉ**

MECHANISCHER OSZILLATOR MIT EINEM OPTIMIERTEN THERMOELASTISCHEN KOEFFIZIENTEN

MECHANICAL OSCILLATOR HAVING AN OPTIMIZED THERMOELASTIC COEFFICIENT

(84) Etats contractants désignés:
**AT BE BG CH CY CZ DE DK EE ES FI FR GB GR HU IE IS IT LI LT LU LV MC MT NL PL PT RO SE SI SK TR**

(43) Date de publication de la demande:
**11.08.2010 Bulletin 2010/32**

(73) Titulaire: **Manufacture et fabrique de montres et de chronomètres Ulysse Nardin Le Locle S.A.
2400 Le Locle (CH)**

(72) Inventeurs:
• **GYGAX, Pierre
CH-2016 Cortaillod (CH)**
• **GLASSEY, Marc-André
CH-1967 Bramois (CH)**

(74) Mandataire: **Scheuzger, Beat Otto
Bovard AG
Patent- und Markenanwälte
Optingenstrasse 16
3000 Bern 25 (CH)**

(56) Documents cités:
**EP-A- 1 422 436      EP-A- 1 837 722
DE-A1- 10 127 733**

**Description**

Domaine technique de l'invention

La présente invention se rapporte au domaine technique général des oscillateurs mécaniques, appelés également résonateurs ou balanciers spirals, utilisés par exemple dans l'horlogerie.

L'invention concerne plus particulièrement des oscillateurs mécaniques comportant un ressort spiral et un balancier et présentant un coefficient thermique qu'il convient de réduire au mieux de manière à limiter la dérive thermique desdits oscillateurs qui influence négativement la précision de la pièce d'horlogerie.

Par coefficient thermique ou thermoélastique, il convient d'entendre la variation en secondes de la marche diurne d'un mouvement d'horlogerie pour une différence de température de 1 °C (ou 1°K).

Etat de la technique

Il est connu, par exemple par l'intermédiaire du document DE 101 27 733 de réaliser des ressorts spiraux présentant une bonne résistance aux contraintes thermiques importantes, ainsi qu'une bonne stabilité de forme. Ces ressorts sont constitués de silicium monocristallin orienté selon divers axes cristallographiques. Un revêtement en oxyde de silicium peut également recouvrir les ressorts en question.

On connaît en outre le document EP 1 422 436, décrivant un procédé pour réduire la dérive thermique d'un spiral seul et atteindre ainsi un coefficient thermique nul. Ce procédé utilise l'anisotropie cristalline du silicium selon un axe cristallographique par rapport à un autre, pour obtenir par l'intermédiaire de calculs d'épaisseur d'un revêtement d'oxyde de silicium permettant de minimiser les coefficients thermiques de la constante de rappel du ressort spiral. Le ressort spiral décrit comporte ainsi idéalement une modulation d'épaisseur. Un tel procédé présente d'un côté une complexité dans sa mise en oeuvre. D'autre côté, les ressorts spiraux fabriqués selon ce procédé (c'est-à-dire les ressorts spiraux optimisés vers un coefficient thermique nulle) ne permettent pas de s'adapter à différents types de balanciers.

Exposé sommaire de l'invention

Les objets de la présente invention visent à pallier les inconvénients précités et à proposer des oscillateurs mécaniques dont la sensibilité aux variations thermiques est minimale.

Un autre objet de la présente invention vise à proposer des oscillateurs mécaniques fiables et précis dont la conception et la fabrication sont simplifiées.

Un autre objet de l'invention vise à proposer un nouveau procédé de conception d'oscillateurs mécaniques, permettant d'utiliser des balanciers très divers (dans les matériaux, la forme et le coefficient de dilatation), tout en conférant à l'oscillateur complet un coefficient thermique très faible, voire nul.

Les objets assignés à l'invention sont atteints à l'aide d'un oscillateur mécanique selon la revendication 1.

On obtient ainsi des oscillateurs mécaniques dont le nombre de battements par heure est quasi invariable en fonction de la température.

Un spiral en silicium monocristallin découpé selon l'axe cristallographique {1,1,1} présente un module d'élasticité isotrope. Il n'est donc pas nécessaire de moduler l'épaisseur d'une spire pour obtenir une déformation uniforme et le second coefficient thermique de la constante de rappel, lié à une anisotropie, comme c'est le cas par exemple pour une orientation selon l'axe cristallographique {1,0,0}, est inexistant.

En outre, le module d'Young est plus élevé pour un spiral gravé selon l'axe cristallographique {1,1,1} que le module moyen pour une gravure selon selon l'axe cristallographique {1,0,0}. Ainsi, pour un ressort spiral de même enroulement, le ressort spiral gravé selon l'axe cristallographique {1,1,1} pourra être plus fin et donc plus léger. Ceci permet de réduire la masse du ressort spiral et donc les variations de marche en fonction de la position.

Un ressort spiral plus fin aura également comme conséquence de nécessiter une quantité moindre d'oxyde pour réaliser un revêtement réalisant la compensation thermique.

A cet endroit, il est important de noter que le ressort spiral selon l'invention et la virole rotative peuvent être fabriqués en deux pièces séparées (utilisant même des matériaux differents) et attachés l'un à l'autre par le biais d'un moyen de fixation quelconque, mais également fabriqués directement en une seule pièce (et un matériau commun), sans qu'un moyen de fixation entre les deux soit nécessaire.

Selon un exemple de réalisation conforme à l'invention, le ressort spiral est dimensionné et fabriqué pour avoir une valeur de coefficient thermique permettant de compenser le coefficient thermique du balancier.

Selon un exemple de réalisation conforme à l'invention, le ressort spiral présente une longueur (L), une section transversale rectangulaire de hauteur (h) et de largeur (l), constantes sur toute la longueur (L).

Selon un exemple de réalisation préférentiel, le revêtement périphérique d'épaisseur (e) est uniforme et comporte au moins une couche de recouvrement de coefficient thermique opposé à celui du silicium. Le revêtement est par exemple en oxyde de silicium (SiO$_2$), même si d'autres matériaux sont également possibles.

Selon un exemple de réalisation de l'oscillateur conforme à l'invention, un moyen de fixation du genre piton est monté et immobilisé sur le ressort spiral, dans une position au voisinage de ladite extrémité excentrique, pour solidariser cette dernière avec l'élément fixe.

Selon un exemple de réalisation de l'oscillateur conforme à l'invention, la virole rotative fait partie intégrante du ressort spiral. Cet exemple de réalisation est particulièrement adapté aux ressorts en silicium, vu que les techniques de fabrications utilisées pour ce cas permettent la fabrication du ressort spiral avec la virole en une seule pièce.

Les objets assignés à l'invention sont également atteints à l'aide d'un procédé de conception d'un oscillateur mécanique selon la revendication 8.

Selon un exemple de mise en oeuvre, le procédé conforme à l'invention consiste à mettre en oeuvre l'étape b) par calcul. La démarche détaillée de la calculation sera décrite plus bas.

Selon un autre exemple de mise en oeuvre, le procédé conforme à l'invention consiste à déterminer les dimensions du ressort spiral (L,h,l) par calcul et à déterminer expérimentalement l'épaisseur (e) du revêtement périphérique, de manière à obtenir un coefficient thermique de l'oscillateur complet, proche de zéro.

Le procédé consiste par exemple à :

- c1) appliquer sur le ressort spiral une couche de revêtement périphérique d'une épaisseur (e1),

- c2) mesurer le coefficient thermique de l'oscillateur complet,

- c3) en fonction du résultat de la mesure effectuée sous c2), reprendre les étapes précédentes, et ce jusqu'à l'obtention d'un coefficient thermique proche de zéro.

Le procédé conforme à l'invention permet ainsi de manière avantageuse de compenser la dérive thermique du balancier à l'aide du ressort spiral, en particulier pour un couple balancier spiral de qualité 1, correspondant à un coefficient thermique inférieur ou égal à +/- 0,6 s/j/deg.

La croissance d'une couche d'oxyde sur un silicium orienté selon l'axe cristallographique {1,1,1} est réalisable par procédé d'oxydation humide et permet de rendre positif le coefficient thermique du ressort spiral et d'obtenir une variation, en fonction de la température, du couple élastique du ressort spiral, compensant la variation en fonction de la température du moment d'inertie du balancier. Il n'est donc plus nécessaire de faire tendre le coefficient thermique de la constante de rappel du spiral vers zéro pour minimiser la dérive thermique de l'oscillateur conforme à l'invention. Il devient possible alors de réaliser de façon simple un ressort spiral particulier, pour un balancier donné, caractérisé par des paramètres physiques déterminés tels que sa masse, son moment d'inertie, sa matière, son rayon de giration et son coefficient de dilatation.

Description brève des dessins

D'autres caractéristiques et avantages apparaîtront plus en détails à la lecture de la description qui suit, ainsi qu'à l'aide des dessins annexés donnés à titre purement illustratif et non limitatif, parmi lesquels :

- la figure 1 illustre un exemple de réalisation d'un ressort spiral utilisé dans l'oscillateur mécanique conforme à l'invention, représenté en perspective ;

- la figure 2 représente un exemple de réalisation d'un oscillateur mécanique conforme à l'invention comprenant le ressort spiral représenté à la figure 1 ;

- la figure 3 représente l'oscillateur mécanique de la figure 1 en vue de dessous ;

- et la figure 4 illustre en coupe, un détail d'un exemple de réalisation d'un ressort spiral d'un oscillateur mécanique conforme à l'invention.

Exposé détaillé de l'invention

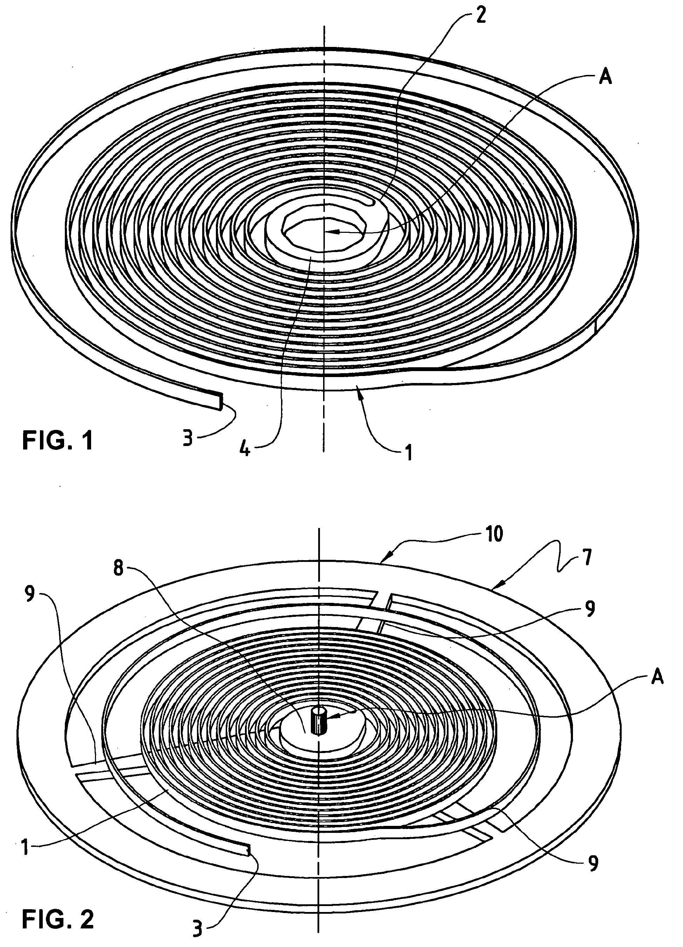

La figure 1 représente un exemple de réalisation d'un ressort spiral 1 qui peut être utilisé dans un oscillateur mécanique conforme à l'invention. Le ressort spiral 1 présente une extrémité centrale 2 et une extrémité excentrique 3. L'extrémité centrale 2 est solidaire d'une virole rotative 4, pourvue d'un orifice destiné à recevoir un arbre de rotation selon l'axe de rotation A (representée par une ligne en pointillé): La virole rotative 4 est destinée à être montée sur un support fixe non représenté. La virole rotative 4 et le ressort spiral 1 peuvent notamment être fabriqués en une seule pièce, sans qu'une fixation séparée soit nécessaire. Il est néanmoins aussi imaginable que la virole rotative 4 soit formée séparément et fixée à l'extrémité centrale 2 du ressort spiral 1 par un moyen de fixation connu. L'extrémité excentrique 3 est destinée à être solidarisée avec un élément fixe appelé « coq » et non représenté aux figures. A cet effet, plusieurs moyens de fixation communs sont possibles.

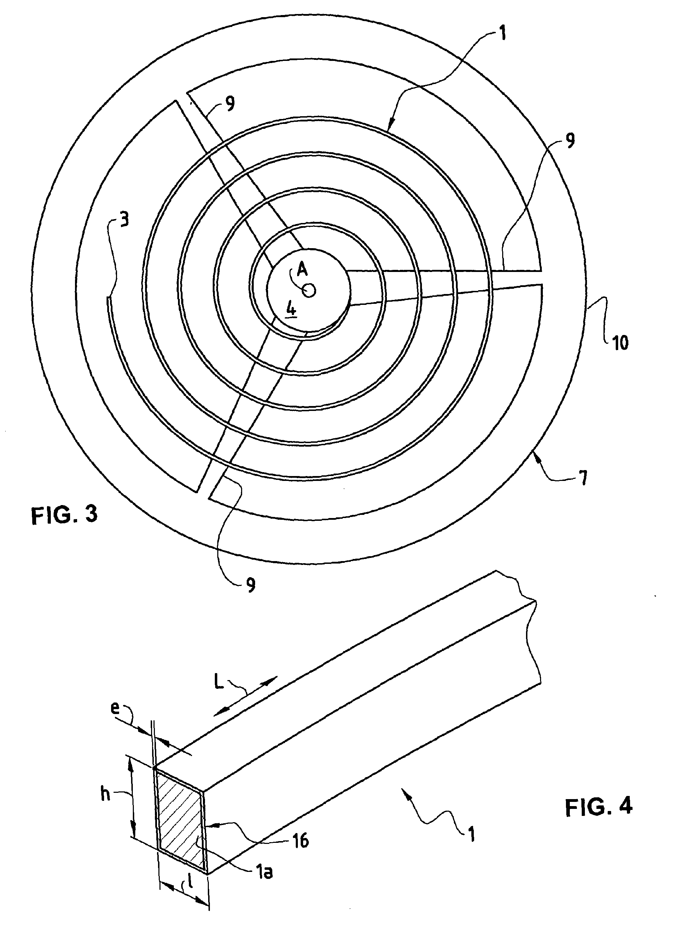

L'oscillateur mécanique conforme à l'invention et représenté aux figures 2 et 3 comporte également un balancier 7 solidaire en rotation de la virole rotative 4 et dont l'axe de rotation est confondu avec l'axe de l'arbre A. Le balancier 7 comporte une partie de montage 8 centrée sur l'arbre A et des bras radiaux 9 reliant ladite partie de montage 8 à une serge 10.

Un exemple de réalisation du ressort spiral 1 est représenté à la figure 4. Le ressort spiral 1 est constitué d'une âme 1a en silicium (Si) monocristallin dont la croissance s'est effectuée suivant l'axe cristallographique {1,1,1} . L'âme 1a, de section transversale rectangulaire, est enrobée d'un revêtement périphérique 1 b d'épaisseur (e). Ce dernier est constitué d'un matériau présentant un coefficient thermoélastique opposé à celui du silicium. A titre d'exemple, ce matériau peut être une couche d'oxydation du genre croissance d' oxyde de silicium ($SiO_2$).

Le ressort spiral 1 présente une longueur (L), une largeur (l) et une hauteur (h). Le nombre de spires N du ressort spiral est déterminé en fonction des propriétés spécifiques recherchées pour chaque oscillateur mécanique. Cette détermination est connue en tant que telle.

Pour illustrer la nécessité de devoir ajuster le coefficient thermique du spiral à celui du balancier on peut considérer la formule de base (I) :

$$Ah = \frac{7200}{2*\pi}\sqrt{\frac{M}{I}}$$

Ah =     Nombre de battement par heure
I =      Moment d'inertie du balancier
M =      Couple élastique du spiral

De cette formule on remarque que pour un même balancier, M étant inchangé, le nombre de battement diminue si l'inertie augmente.

Le tableau ci-après nous montre l'influence de la différence du coefficient thermique due à deux balanciers réalisés en matériaux ayant un coefficient de dilatation différent. Le résultat est calculé en utilisant les formules suivantes nommées (II) et (III) dans la formule de base (I).

## Formule (II) : Calcul de l'inertie

$$I = m * r^2$$

I =     Moment d'inertie du balancier
m =     Masse du balancier
r =     Rayon de giration du balancier

## Formule (III) : l'inertie en fonction de T = I(T)

$$I(T) = m * ((T * \alpha + 1) * r)^2$$

I = Moment d'inertie du balancier
m = Masse du balancier
r = Rayon de giration du balancier
T = Différence de temperatur par rapport à 20°
a = Coefficient de dilatation

Tableau 1 : (base 28800alt/heures, rayon 5mm)

| Matériel | Coefficient de dilatation | Delta battementlhlde g | Coefficient thermique: CT (sljl deg) |
|----------|---------------------------|------------------------|--------------------------------------|
| CuBe | $18*10{-6}$ | -0.52 | -1,56 |
| Platine | $9*10{-6}$ | -0.26 | -0,78 |

L'influence de la température sur le balancier uniquement.

Pour que Ah(T) soit invariable il est nécessaire que la variation de M(T) et de I(T) en fonction de T soient de même signe et de même valeur. On peut constater les effets de M(T) et de I(T) dans la formule (I).

Ce qui revient à dire que dM/dT = dI/dT.

I(T), le moment d'inertie en fonction de la température est décrit dans la formule (III).

M(T), le couple élastique du spiral peut alors être calculé dans le cas d'un spiral en silicium recouvert d'une couche d'oxyde uniforme à l'aide des formules suivantes :

## Formule (IV) :

$$M(T) = M_{si} * (1 + CTE_{si}) + M_{ox} * (1 + CTE_{ox})$$

M = Couple élastique du spiral
$M_{si}$ = Couple élastique du au silicium
$M_{ox}$ = Couple élastique du à l'oxyde
$CTE_{si}$ = Coefficient élastique du silicium
$CTE_{ox}$ = Coefficient élastique de l'oxyde

## Formule (V) :

$$M_{si} = \frac{E_{si} * (h - 2e) * (l - 2e)^3}{12L}$$

$E_{si}$ = Module d'élasticité du silicium
h = Hauteur de la lame
l = Epaisseur de la lame
L = Longueur du spiral déroulé
e = Epaisseur de l'oxyde

## Formule (VI) :

$$M_{ox} = \frac{E_{ox}}{12L} * ((h) * (l)^3) - ((h - 2e) * (l - 2e)^3)$$

$E_{ox}$ = Module d'élasticité du silicium
h = Hauteur de la lame
l = Epaisseur de la lame
L = Longueur du spiral déroulé
e = Epaisseur de l'oxyde

**Revendications**

1. Oscillateur mécanique, notamment pour l'horlogerie, comportant un ressort spiral (1) présentant un nombre de N spires, une extrémité centrale (2), une extrémité excentrique (3) et une virole rotative (4) en connexion avec l'extrémité centrale (2) comportant un orifice destiné à recevoir un arbre de rotation autour d'un axe (A), ainsi qu'un balancier (7) dont l'axe de rotation est confondu avec l'arbre de rotation (A), l'extrémité excentrique (3) étant destinée à être solidarisée avec un élément fixe du genre « coq », ledit ressort spiral (1) étant constitué d'une âme (1a) en silicium (Si) monocristallin et d'au moins un revêtement périphérique (1b) à base d'un matériau présentant un coefficient thermoélastique différent de celui du silicium,
**caractérisé en ce que**
la découpe du silicium (Si) monocristallin est orientée selon l'axe cristallographique {1,1,1} et le revêtement est choisi pour obtenir une variation, en fonction de la température, du couple élastique du ressort spiral, compensant la variation en fonction de la température du moment d'inertie du balancier.

2. Oscillateur mécanique selon la revendication 1, **caractérisé en ce que** le ressort spiral (1) est dimensionné et fabriqué pour avoir une valeur de coefficient thermique permettant de compenser le coefficient thermique du balancier (7).

3. Oscillateur mécanique selon la revendication 1 ou 2, **caractérisé en ce que** le ressort spiral (1) présente une longueur (L), une section transversale rectangulaire de hauteur (h) et de largeur (l), constantes sur toute la longueur (L).

4. Oscillateur mécanique selon l'une quelconque des revendications 1 à 3, **caractérisé en ce que** le revêtement périphérique (1b) d'épaisseur (e) est uniforme et comporte au moins une couche de recouvrement de coefficient thermique opposé à celui du silicium.

5. Oscillateur mécanique selon la revendication 4, **caractérisé en ce que** la couche d'oxydation est une croissance d'oxyde de silicium ($SiO_2$).

6. Oscillateur mécanique selon l'une quelconque des revendications 1 à 5, **caractérisé en ce qu'**un moyen de fixation du genre piton est monté et immobilisé sur le ressort spiral, dans une position au voisinage de ladite extrémité excentrique, pour solidariser cette dernière avec l'élément fixe.

7. Oscillateur mécanique selon l'une quelconque des revendications 1 à 6, **caractérisé en ce que** la virole rotative (4) fait partie intégrante du ressort spiral (1).

8. Procédé de conception d'un oscillateur mécanique conforme à l'une quelconque des revendications 1 à 7, **caractérisé en ce qu'**il consiste à optimiser le coefficient de température de l'oscillateur complet pour limiter sa dérive thermique en :

a) utilisant du silicium (Si) monocristallin gravé selon l'axe cristallographique {1,1,1} pour réaliser le ressort spiral (1),
b) déterminant, en fonction des paramètres physiques particuliers du balancier liés à sa forme et à sa matière constitutive, les dimensions du ressort spiral (L,h,l) et l'épaisseur (e) du revêtement périphérique (1b).

9. Procédé selon la revendication 8, **caractérisé en ce qu'**il consiste à mettre en oeuvre l'étape b) par calcul.

10. Procédé selon la revendication 8, **caractérisé en ce qu'**il consiste à déterminer les dimensions du ressort spiral (L,h,l) par calcul et à déterminer expérimentalement l'épaisseur (e) du revêtement périphérique (1b), de manière à obtenir un coefficient thermique de l'oscillateur complet proche de zéro.

11. Procédé selon la revendication 10, **caractérisé en ce qu'**il consiste à :

c1) appliquer sur le ressort spiral (1) une couche de revêtement périphérique (1b) d'une épaisseur (e1),
c2) mesurer le coefficient thermique de l'oscillateur complet,
c3) en fonction du résultat de la mesure effectuée sous c2), reprendre les étapes précédentes et ce jusqu'à l'obtention d'un coefficient thermique proche de zéro.

**Claims**

1. Mechanical oscillator, in particular for watchmaking, comprising a spiral spring (1) having a number N of turns, a central end (2), an eccentric end (3) and a rotary collet (4) connected to the central end (2), comprising an orifice intended to receive an arbor for rotation about an axis (A), and a balance (7), the axis of rotation of which coincides with the rotation arbor (A), the eccentric end (3) being intended to be integral with a stationary element of the "balance-cock" type, said spiral spring (1) being made up of a single-crystal silicon (Si) core (1a) and at least one peripheral coating (1 b) based on a material having a thermoelastic coefficient different from that of silicon, **characterised in that** the cutting of the single-crystal silicon (Si) is oriented along the crystallographic axis {1,1,1} and the coating is selected to obtain a variation, as a function of the temperature, of the resilient torque of the spiral spring, compensating the variation in function of the temperature at the moment of inertia of the balance.

2. Mechanical oscillator according to claim 1, **characterised in that** the spiral spring (1) is dimensioned and manufactured to have a temperature coefficient value allowing compensation of the temperature coefficient of the balance (7).

3. Mechanical oscillator according to claim 1 or 2, **characterised in that** the spiral spring (1) has a length (L), a rectangular cross section of height (h) and of width (l) constant over the entire length (L).

4. Mechanical oscillator according to any one of the claims 1 to 3, **characterised in that** the peripheral coating (1 b) of thickness (e) is uniform and comprises at least one layer of coating of temperature coefficient opposite that of silicon.

5. Mechanical oscillator according to claim 4, **characterised in that** the oxidation layer is a growth of silicon dioxide (SiO$_2$).

6. Mechanical oscillator according to any one of the claims 1 to 5, **characterised in that** a means of attachment of the stud type is mounted and secured in a stationary way on the spiral spring, in a position in proximity to said eccentric end, to connect the latter in an integral way to the fixed element.

7. Mechanical oscillator according to any one of the claims 1 to 6, **characterised in that** the rotary collet (4) forms an integral part of the spiral spring (1).

8. Method of design of a mechanical oscillator according to any one of the claims 1 to 7, **characterised in that** it consists in optimizing the temperature coefficient of the complete oscillator in order to limit its thermal drift by :

   a) using single-crystal silicon (Si) engraved along the crystallographic axis {1,1,1} to achieve the spiral spring (1),
   b) determining, depending upon particular physical parameters of the balance connected with its form and its constituent material, the dimensions of the spiral spring (L,h,l) and the thickness (e) of the peripheral coating (1b).

9. Method according to claim 8, **characterised in that** it comprises carrying out step b) by calculation.

10. Method according to claim 8, **characterised in that** it comprises determining the dimensions of the spiral spring (L,h,l) by calculation and determining experimentally the thickness (e) of the peripheral coating (1 b), in such a way as to obtain a temperature coefficient for the entire oscillator close to zero.

11. Method according to claim 10, **characterised in that** it comprises:

   c1) applying to the spiral spring (1) a layer of peripheral coating (1 b) of a thickness (e1),
   c2) measuring the temperature coefficient of the entire oscillator,
   c3) depending upon the result of the measurement carried out under c2), repeating the preceding steps and this until a temperature coefficient close to zero is obtained.

**Patentansprüche**

1. Mechanischer Oszillator, insbesondere für die Uhrmacherei, umfassend eine Spiralfeder (1) mit einer Anzahl N von Windungen, ein zentrisches Ende (2), ein exzentrisches Ende (3) und eine Spiralrolle (4), die mit dem zentrischen Ende (2) in Verbindung steht, und die eine Öffnung aufweist, welche zum Aufnehmen einer Welle zur Drehung um eine Achse (A) vorgesehen ist, sowie eine Unruh (7) deren Drehachse mit der Welle (A) übereinstimmt, wobei das exzentrische Ende (3) zur Verbindung mit einem fixen Elementen des Typs "Unruhkloben" vorgesehen ist, wobei die Spiralfeder (1) aus einem Innenbereich (1 a) aus monokristallinem Silizium und aus mindestens einer Aussenbeschichtung (1 b) aus einem Material, dessen thermoelastischer Koeffizient von demjenigen von Silizium unterschiedlich ist, besteht,
   **dadurch gekennzeichnet, dass**
   der Zuschnitt des monokristallinen Siliziums (Si) in Richtung der kristallographischen Achse {1,1,1} so orientiert und die Beschichtung so gewählt ist, dass eine Variation des elastischen Drehmoments der Spiralfeder in Abhängigkeit von der Temperatur erreicht wird, bei welcher die Variation des Trägheitsmoments der Unruh in Abhängigkeit von der Temperatur kompensiert wird.

2. Mechanischer Oszillator gemäss Anspruch 1, **dadurch gekennzeichnet, dass** die Spiralfeder (1) so dimensioniert und produziert wird, dass sie einen Wert des thermischen Koeffizienten hat, welcher es erlaubt, den thermischen Koeffizienten der Unruh (7) zu kompensieren.

3. Mechanischer Oszillator gemäss Anspruch 1 oder 2, **dadurch gekennzeichnet, dass** die Spiralfeder (1) eine Länge (L), einen rechteckigen Querschnitt mit der Höhe (h) und mit der Breite (l) aufweist, welche entlang der gesamten Länge (L) konstant sind.

4. Mechanischer Oszillator gemäss einem der Ansprüche 1 bis 3, **dadurch gekennzeichnet, dass** die Aussenbeschichtung (1 b) mit der Dicke (3) einheitlich ist, und dass sie mindestens eine Deckschicht aufweist, deren thermischer Koeffizient demjenigen des Silizium entgegengesetzt ist.

5. Mechanischer Oszillator nach Anspruch 4, **dadurch gekennzeichnet, dass** die Oxydationsschicht ein gewachsenes Siliziumoxid (SiO$_2$) ist.

6. Mechanischer Oszillator gemäss einem der Ansprüche 1 bis 5, **dadurch gekennzeichnet, dass** ein Befestigungsmittel des Typs Spiralklötzchens an einer Stelle auf der Spiralfeder gelegt und blockiert ist, welche sich in der Nähe des exzentrischen Endes befindet, um die letztere mit dem fixen Elementen zusammen zu bringen.

7. Mechanischer Oszillator gemäss einem der Ansprüche 1 bis 6, **dadurch gekennzeichnet, dass** die Spiralrolle (4) ein Teil der Spiralfeder (1) ist.

8. Verfahren zur Gestaltung eines mechanischen Oszillators gemäss einem der Ansprüche 1 bis 7, **dadurch gekennzeichnet, dass** der darin besteht, den thermischen Koeffizienten des gesamten Oszillators zu optimieren, um seine thermische Abdrift zu begrenzen, indem:

a) monokristallines Silizium (Si) gemäss der kristallographischen Achse {1,1,1} geätzt wird, um die Spirale (1) zu realisieren,
b) in Abhängigkeit von den besonderen physischen Parametern der Unruh, welche mit ihrer Form und mit ihrem Baumaterial zusammenhängen, die Dimensionen der Spiralfeder (L,h,l) und die Dicke (e) der Aussenbeschichtung (1 b) bestimmt werden.

9. Verfahren gemäss Anspruch 8, **dadurch gekennzeichnet, dass** es darin besteht, den Schritt b) durch Berechnung durchzuführen.

10. Verfahren gemäss Anspruch 8, **dadurch gekennzeichnet, dass** es darin besteht, die Dimensionen der Spiralfeder (L,h,l) durch Berechnung, und die Dicke der Aussenbeschichtung (1 b) durch Versuche zu bestimmen, so dass Wert des thermischen Koeffizienten des gesamten Oszillators nahe Null erreicht wird.

11. Verfahren nach Anspruch 10, **dadurch gekennzeichnet, dass** es darin besteht:

c1) auf die Spiralfeder (1) eine Schicht der Aussenbeschichtung (1 b) mit einer Dicke (e1) aufzutragen,
c2) den thermischen Koeffizienten des gesamten Oszillators zu messen,
c3) die vorherigen Schritte in Abhängigkeit vom Resultat der unter c2) realisierten Messung zu wiederholen, bis ein Wert des thermischen Koeffizienten nahe Null erreicht wird.

FIG. 1

FIG. 2

FIG. 3

FIG. 4

**EP 2 215 531 B1**

**RÉFÉRENCES CITÉES DANS LA DESCRIPTION**

**Documents brevets cités dans la description**

- DE 10127733
- EP 1422436 A